# EUROPÄISCHE PATENTANMELDUNG

(11) **EP 0 987 756 A2**
(43) Veröffentlichungstag der Anmeldung: **22.03.2000**
(21) Anmeldenummer: 99118400.3
(22) Anmeldetag: 16.09.1999
(51) Int. Cl.: H01L 21/8242

(54) **Gestapelter Flossenkondensator für DRAM und Verfahren zur Herstellung desselben**

(30) Priorität: 17.09.1998 DE 19842684
(71) Anmelder: SIEMENS AKTIENGESELLSCHAFT, 80333 München (DE)
(72) Erfinder: Lange, Gerrit, Dr., 81373 München (DE); Schlösser, Till, Dr., 81825 München (DE)

(57) **Zusammenfassung**

Kondensator mit einem hoch-ε-dielektrischen oder ferroelektrischen Kondensatordielektrikum (9), dessen edelmetallhaltige Speicherelektrode auf einem Stützgerüst, das mehrere Lamellen (5₁) aufweist und mit einem Träger verbunden ist, angeordnet ist. Das Stützgerüst kann beispielsweise durch Abscheiden einer Schichtenfolge mit alternierend niedriger und hoher Ätzrate, Ätzen zur Schichtstruktur, Bilden eines Verbindungsteils, und selektives Entfernen der Schichten mit hoher Ätzrate hergestellt werden.

## Beschreibung

Die Erfindung betrifft einen auf einem Stützgerüst angeordneten Kondensator in einer integrierten Schaltung, bei dem als Kondensatordielektrikum ein hoch-ε-Dielektrikum oder ein Ferroelektrikum eingesetzt wird.

In einer großen Anzahl von integrierten Halbleiterschaltungen werden Kondensatoren benötigt, beispielsweise in DRAM-Schaltungen oder A/D-Wandlern. Dabei ist die Erhöhung der Integrationsdichte ein vorrangiges Ziel, d.h. es muß eine möglichst hohe oder für die Anforderungen ausreichende Kapazität mit minimalem Platzbedarf realisiert werden. Dieses Problem stellt sich insbesondere bei DRAM-Schaltungen, bei denen jede Speicherzelle einen Speicherkondensator und einen Auswahltransistor aufweist, wobei die für eine Speicherzelle zur Verfügung stehende Fläche fortlaufend reduziert wird. Gleichzeitig muß zur sicheren Speicherung der Ladung und Unterscheidbarkeit der auszulesenden Information eine gewisse Mindestkapazität des Speicherkondensators erhalten bleiben. Diese Mindestkapazität wird derzeit bei etwa 25 fF gesehen.

Zur Verringerung des Platzbedarfs eines Kondensators kann als Kondensatordielektrikum ein Paraelektrikum mit hoher Permittivität (hoch-ε-Dielektrikum) verwendet werden. In Speicheranordnungen werden solche Kondensatoren vorzugsweise als sogenannte 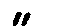 stacked"-Kondensatoren (der Kondensator der Zelle ist oberhalb des zugehörigen Auswahltransistors angeordnet) eingesetzt. Speicherzellen, die als Kondensatordielektrikum paraelektrische Materialien benutzen, verlieren bei Auswahl der Versorgungsspannung ihre Ladung und somit ihre gespeicherte Information. Ferner müssen diese Zellen wegen des Rest-Leckstroms ständig neu beschrieben werden (Refresh-Time). Der Einsatz eines ferroelektrischen Materials als Kondensatordielektrikum ermöglicht dagegen aufgrund der unterschiedlichen Polarisationsrichtungen des Ferroelektrikums den Bau eines nicht-flüchtigen Speichers (FRAM), der seine Information bei Auswahl der Versorgungsspannung nicht verliert und auch nicht ständig neu beschrieben werden muß. Der Rest-Leckstrom der Zelle beeinflußt nicht das gespeicherte Signal.

Verschiedene hoch-(-Dielektrika und Ferroelektrika sind aus der Literatur bekannt, beispielsweise Barium-Strontium-Titanat (BST), Strontium-Titanat (ST) oder Blei-Zirconium-Titanat (BZT), ferner ferro- und paraelektrische Polymere und anderes.

Obwohl diese Materialien die gewünschten elektrischen Eigenschaften aufweisen, ist ihre Bedeutung in der Praxis noch begrenzt. Eine wesentliche Ursache dafür ist, daß die genannten Materialien nicht ohne weiteres in Halbleiteranordnungen eingesetzt werden können. Die Herstellung der Materialien erfolgt durch einen Sputter-on- oder Abscheideprozess, der hohe Temperaturen in einer sauerstoffhaltigen Atmosphäre benötigt. Dies hat zur Folge, daß die in der Halbleitertechnologie als Elektrodenmaterial verwendeten leitfähigen Materialien (z.B. Polysilizium, Aluminium oder Wolfram) ungeeignet sind, da sie unter diesen Bedingungen oxidieren. Daher wird zumindest die erste Elektrode üblicherweise aus einem edelmetallhaltigen Material wie Platin oder Ruthenium hergestellt. Diese neuen Elektrodenmaterialen sind jedoch für die Halbleitertechnologie relativ unbekannte Substanzen. Sie sind schwierig aufzubringen und nur bei geringer Schichtdicke befriedigend strukturierbar. Ferner sind sie sauerstoffdurchlässig, was zur Folge hat, daß während der Herstellung des Kondensatordielektrikums tieferliegende Strukturen oxidiert werden und ein ausreichender Kontakt zwischen erster Elektrode und dem Auswahltransistor nicht gewährleistet ist. Daher ist eine Barriere unterhalb des Kondensatordielektrikums notwendig, die eine Sauerstoffdiffusion unterdrückt.

In DE-Patentschrift 196 40 448 und WO 98/14992 ist eine derartige Speicherzelle beschrieben, bei der die Barriere zwischen der ersten Elektrode und der Anschlußstruktur zum Auswahltransistor ganzflächig durch eine Nitridation erzeugt wird. In der DE-OS 196 40 244 und WO 98/15014 ist ein Kondensator mit einem hoch-ε-dielektrischen oder ferroelektrischen Kondensatordielektrikum beschrieben, bei dem die erste Elektrode aus einem Elektrodenkern und einer demgegenüber dünnen edelmetallhaltigen Schicht besteht, und bei dem der Elektrodenkern aus dem Material der Anschlußstruktur oder der Oxidationsbarriere besteht. Dies hat den Vorteil, daß lediglich eine dünne edelmetallaltige Schicht strukturiert werden muß.

Allen diesen Kondensatoren mit einem hoch-ε-dielektrischen oder ferroelektrischen Kondensatordielektrikum ist gemeinsam, daß eine im Prinzip planare Anordnung der ersten Elektrode vorgesehen ist.

In US 5,581,436 ist als erste Elektrode eines Kondensators der in Rede stehenden Art eine dünne Platinschicht auf der Oberfläche eines Elektrodenkerns aufgebracht. Ggf. kann das Hoch-ε-Dielektrikum als frei stehende Struktur vor der Bildung der ersten und zweiten Elektrode hergestellt werden, d.h. die Elektroden werden dann an den Seitenwänden des Dielektrikums gebildet.

Aufgabe der vorliegenden Erfindung ist es, bei einem Kondensator mit einem hoch-ε-dielektrischen oder ferroelektrischen Kondensatordielektrikum den Platzbedarf weiter zu verringern, sowie ein einfaches und mit den üblichen Herstellprozessen verträgliches Herstellverfahren für einen solchen Kondensator anzugeben.

Diese Aufgabe wird durch einen Kondensator mit den Merkmalen des Anspruchs 1 bzw. durch ein Herstellverfahren mit den Merkmalen des Anspruchs 7 gelöst.

Die Erfindung beruht auf der Verwendung eines Stützgerüstes für die edelmetallhaltige erste Elektrode des Kondensators, das eine gegenüber seiner Projektion auf die Trägeroberfläche wesentlich vergrößerte Oberfläche aufweist. Das Stützgerüst umfaßt mindestens zwei voneinander beabstandete Lamellen, die im wesentlichen parallel zur Trägeroberfläche liegen und über ein Verbindungsteil mit dem Träger verbunden sind. Die edelmetallhaltige erste Elektrode bedeckt die Oberfläche der Lamellen und des Verbindungsteils, so daß die kapazitätswirksame Fläche vergrößert wird. Die zweite Elektrode des Kondensators ist von der ersten Elektrode durch ein hoch-ε-Dielektrikum oder Ferroelektrikum getrennt.

Das Stützgerüst kann in vielen verschiedenen Ausführungsformen realisiert werden. Das Verbindungsteil verbindet vorzugsweise auch die Lamellen miteinander und kann an einer oder an mehreren Seiten der Lamellen angeordnet sein, es kann aber auch im Innern durch die Lamellen verlaufen. Das Stützgerüst kann im Prinzip jede Form annehmen, die als erste Elektrode bei sogenannten 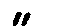 fin-stack-Kondensatoren" bekannt ist. Derartige fin-stack-Kondensatoren sind beispielsweise in EP 415 530 B1, EP 779 656 A2, EP 756 326 A1 und in den noch nicht veröffentlichten DE-Patentanmeldungen Nr. 198 21 910.5, 198 21 776.5 und 198 21 777.3 beschrieben. Bei der hier vorliegenden Erfindung dienen die dort beschriebenen Elektrodenstrukturen aber lediglich als Stützgerüst für die edelmetallhaltige erste Elektrode. Daher besteht eine größere Auswahl für das Material des Stützgerüstes, das auch aus einem Isolator bestehen kann, und das Verbindungsteil braucht die Lamellen nicht elektrisch, sondern lediglich mechanisch mit dem Träger zu verbinden.

Der Träger kann einen Anschluß für die erste Elektrode enthalten, wobei die übrige Trägeroberfläche mit einer Isolierschicht bedeckt ist. Dann bedeckt die edelmetallhaltige erste Elektrode einen Teil der Trägeroberfläche und überdeckt diesen Anschluß, so daß ein elektrischer Kontakt gewährleistet ist.

Als Material für die erste Elektrode ist insbesondere Platin, aber auch Rutheniumoxid und andere edelmetallhaltige Materialien geeignet, die für den Einsatz in einem hoch-ε- oder ferroelektrischen Kondensator bekannt sind. Die zweite Elektrode besteht vorzugsweise aus demselben Material wie die erste, kann aber auch aus einem anderen geeigneten Material, beispielsweise einem anderen Metall oder dotiertem Polysilizium, gebildet werden.

Vorzugsweise wird der Kondensator in einer DRAM-Zelle eingesetzt. Dann enthält der Träger den zugehörigen MOS-Auswahltransistor. Ein S/D-Gebiet des Transistors wird über den erläuterten Anschluß mit der ersten Elektrode verbunden. Der Anschluß weist vorzugsweise in seinem oberen Bereich eine leitende Sauerstoffbarriere auf (beispielsweise Titannitrid) und besteht im übrigen aus beispielsweise Titan, Polysilizium, Wolfram oder ähnlichem.

Zur Herstellung des Kondensators wird auf dem Träger zunächst das Stützgerüst erzeugt. Auf das Stützgerüst wird konform das Elektrodenmaterial, beispielsweise Platin, Iridium oder Rutheniumoxid, konform abgeschieden. Das Elektrodenmaterial wird mit Hilfe einer Fototechnik zu einer ersten Elektrode strukturiert. Eventuell wird vor dem Aufbringen der für die Fototechnik benötigten Lackschicht eine Hilfsschicht auf den Träger aufgebracht, insbesondere um die Höhenunterschiede zwischen der Trägeroberfläche und der Oberkante der Elektrodenstruktur auszugleichen, die zu Problemen bei der Belichtung des Fotolacks führen können. In diesem Fall werden mit der Lackmaske diese Hilfsschicht und das Elektrodenmaterial strukturiert, dann wird die Hilfsschicht selektiv zum Elektrodenmaterial entfernt. Nach der Strukturierung der ersten Elektrode wird ein hoch-ε-Dielektrikum oder Ferroelektrikum mit einem bekannten Verfahren konform aufgebracht, dann wird die Gegenelektrode hergestellt.

Ein Vorteil des erfindungsgemäßen Verfahrens ist, daß keine stark anisotrope Ätzung des Elektrodenmaterials notwendig ist.

Zur Herstellung des Stützgerüstes wird auf einem Träger, der eine Isolationsschicht mit einem darin eingebetteten Anschluß enthalten kann, eine Schichtenfolge erzeugt, die jeweils alternierend eine Schicht aus einem ersten Material und eine Schicht aus einem zweiten Material aufweist, wobei das zweite Material zum ersten selektiv ätzbar ist. Die Schichtenfolge wird bis zum Träger strukturiert, so daß eine Schichtstruktur mit Flanken gebildet wird. Es wird das Verbindungsteil an mindestens einer Flanke erzeugt, wozu insbesondere eine Schrägimplantation, eine konforme Abscheidung mit anschließender anisotroper Ätzung zur Bildung eines Spacers, oder eine selektive Epitaxie auf den freiliegenden Oberflächen der Schichtstruktur eingesetzt werden können. Bei den letzten beiden Verfahren wird dann eine Öffnung in die Schichtstruktur geätzt, um eine Oberfläche der Schichten freizulegen und mit einer selektiven Ätzung die Schichten aus dem zweiten Material entfernen zu können.

Die Öffnung kann an den Rand der Schichtstruktur gelegt werden, so daß hier die das Verbindungsteil bildende Schicht und evtl. ein Randbereich der Schichtstruktur entfernt werden.

Die Öffnung kann andererseits im Innern der Schichtstruktur erzeugt werden. Dadurch wird eine besonders hohe Stabilität beim Herausätzen des zweiten Materials gewährleistet, da das Verbindungsteil an allen außenliegenden Flanken des Stützgerüstes vorhanden ist. Die Schichten aus dem ersten Material können daher sehr dünn sein, bspw. 20 - 30 nm.

Zwischen dem Träger und der Schichtenfolge kann eine als Atzstop dienende Hilfsschicht aufgebracht werden. Die unterste Schicht der Schichtenfolge ist dann vorzugsweise eine Schicht aus dem ersten Material. Die Ätzung zur Bildung der Schichtstruktur kann dann ebenso wie die Erzeugung der Öffnung in zwei Ätzschritten erfolgen, wobei der erste Ätzschritt selektiv zur Hilfsschicht ist. Ein evtl. im Träger vorhandenes Kontaktloch bzw. Barriere wird durch dises Verfahren besonders gut geschützt.Dieser Vorteil kommt besonders bei einer Öffnung im Innern des Stützgerüstes zum Tragen, da bei der Herstellung der Öffnung entweder bis auf den Träger oder bis auf die direkt auf dem Träger liegende Schicht (die in jedem Fall nicht resistent gegen den eingesetzten Ätzprozeß ist) hinuntergeätzt werden muß, wobei in diesem Bereich der Trägeroberfläche vorzugsweise das Kontaktloch angeordnet ist. Ohne Hilfsschicht kann die Gefahr der Anätzung der Barriere bestehen. Ferner hängt es von der Wahl des ersten und zweiten Materials, der Trägeroberfläche und der Barriere ab, ob der Einsatz einer Hilfsschicht vorteilhaft ist. Wenn das erste Material dasselbe wie das der Trägeroberfläche ist, ermöglicht die Hilfsschicht insb. einen sicheren Ätzstop bei der Bildung der Schichtstruktur. Als Hilfsschicht ist bspw. Siliziumoxid (speziell TEOS) oder Nitrid geeignet.

Zur Herstellung des Stützgerüstes können die in den oben zitierten Patentanmeldungen beschriebenen Verfahren eingesetzt werden. Wie schon erläutert, besteht aber eine größere Freiheit in der Auswahl geeigneter Materialien, da es nur auf eine geeignete geometrische Form des zu erzeugenden Stützgerüstes ankommt. Das bedeutet, daß auch bei den Ätzprozessen größere Auswahlmöglichkeiten bestehen. Für den Einsatz als Stützgerüst kann die Schichtenfolge (1./2. Material) bspw. aus p⁺-Polysilizium/p⁻-Polysilizium, Silizium/Germanium, n-Polysilizium/Polysilizium, Siliziumoxid/Siliziumnitrid, Siliziumnitrid/Siliziumoxid, Siliziumoxid/(ggf. dotiertes)Polysilizium und anderen Kombinationen bestehen; aus dem ersten Material werden dann die Lamellen gebildet. Das Verbindungsteil wird vorzugsweise ebenfalls aus dem ersten Material gebildet, um die spätere selektive Ätzung des zweiten Materials nicht zu erschweren. Das Stützgerüst kann aus demselben (isolierenden) Material wie die Trägeroberfläche bestehen, so daß die selektive Entfernung der Schichten aus dem zweiten Material besonders einfach ist bzw. eine große Wahlfreiheit für das zweite Material und den selektiven Ätzprozess besteht. Allerdings besteht dann keine Selektivität zum Träger beim Ätzen zur Schichtstruktur, wenn keine Hilfsschicht eingesetzt wird. Für germaniumhaltige Schichten sind Hersteliverfahren und Ätzverfahren in der DE-Anmeldung 19707977.6 beschrieben.

Die Erfindung wird im folgenden anhand der Figuren und der Ausführungsbeispiele näher erläutert.
Figur 1 bis 6 zeigt einen Querschnitt durch ein Substrat, an dem ein erstes Ausführungsbeispiel des Verfahrens anhand einer DRAM-Speicherzelle verdeutlicht wird.
Figur 7 bis 12 zeigt entsprechend ein zweites Ausführungsbeispiel.

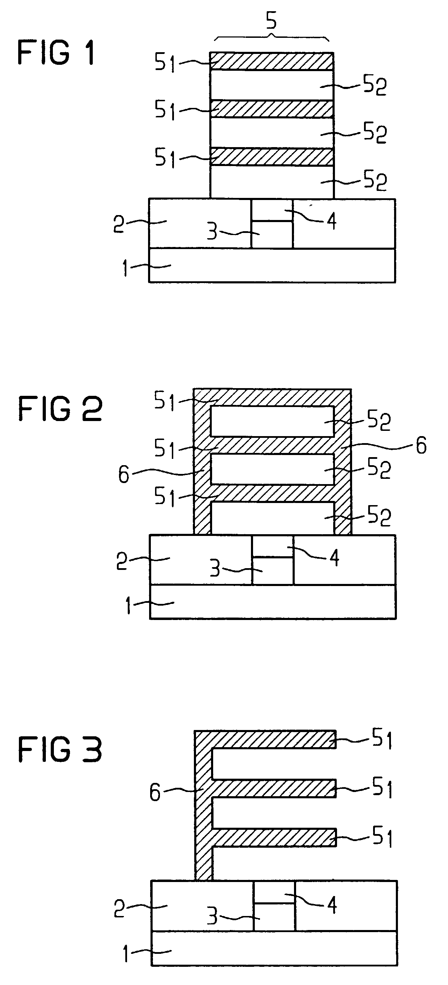

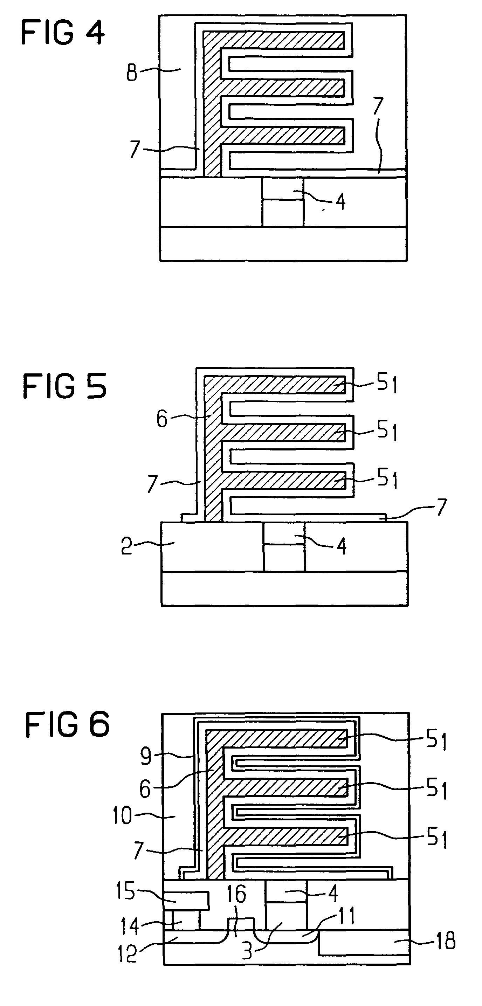

FIG 1: Auf ein Substrat 1 wird eine isolierende Schicht 2 aufgebracht. Das Substrat 1 ist beispielsweise ein Siliziumsubstrat, das Auswahltransistoren mit Wortleitungen und Bitleitungen umfaßt (s. Fig.6). Die isolierende Schicht wird beispielsweise aus Siliziumoxid gebildet und planarisiert. In der isolierenden Schicht 2 werden Kontaktlöcher 3 geöffnet und mit elektrisch leitfähigem Material, beispielsweise mit dotiertem Polysilizium, Wolfram, Tantal, Titan, Titannitrid oder Wolframsilizid aufgefüllt. Die Kontaktlöcher 3 werden so angeordnet, daß sie jeweils auf ein Source-/Draingebiet eines Auswahltransistors im Substrat 1 reichen. Vorzugsweise im oberen Teil des Kontaktlochs 3 ist eine Barriere 4 angeordnet, die eine Sauerstoffdiffusion unterdrückt. Verfahren zur Herstellung einer solchen Barriere sind beispielsweise aus DE-196 40 448 oder DE-196 40 246 bekannt. Auf diesem Träger wird nun das Stützgerüst hergestellt, indem zunächst eine Schichtenfolge aufgebracht wird, die alternierend eine Schicht 5₁ aus einem ersten Material und eine Schicht 5₂ aus einem zweiten Material umfaßt. Beispielsweise besteht das erste Material aus Siliziumoxid und das zweite Material aus undotiertem oder dotiertem Polysilizium. Weiter kann das erste Material aus p⁺-dotiertem Polysilizium und das zweite Material aus p⁻-dotiertem Polysilizium bestehen. Allgemein muß das erste Material eine geeignete Unterlage für eine edelmetallhaltige Schicht bilden, und das zweite Material muß zum ersten Material und zur Trägeroberfläche(oder zu einer evtl. Hilfsschicht) sowie ggf. zum Barrierenmaterial selektiv ätzbar sein. In diesem Ausführungsbeispiel wird direkt auf die Trägeroberfläche die Schicht aus dem zweiten Material aufgebracht. Die oberste Schicht der Schichtenfolge besteht in diesem Ausführungsbeispiel aus dem ersten Material. Anschließend wird aus der Schichtenfolge 5 durch anisotropes Ätzen unter Verwendung einer Maske eine Schichtstruktur 5 gebildet. Neben der Schichtstruktur liegt die Oberfläche der isolierenden Schicht 2 frei.

FIG 2: An den Seitenwände der Schichtstruktur 5 werden Spacer 6 vorzugsweise aus dem ersten Material gebildet, indem eine Schicht aus dem ersten Material konform abgeschieden und anisotrop zurückgeätzt wird.

FIG 3: Dann wird eine Öffnung in diese Struktur geätzt, die die Flanken der Schichten aus dem ersten und aus dem zweiten Material freilegt. In diesem Ausführungsbeispiel wird diese Öffnung an die Seite der Struktur gelegt, d.h. es werden der an einer Seite befindliche Spacer und ein angrenzender Randbereich der Schichtstruktur 5 mit einem geeigneten Ätzprozess unter Einsatz einer Fotomaske entfernt. Die Öffnung kann aber auch an eine andere Stelle gelegt werden, wesentlich ist lediglich, daß mindestens eine Oberfläche bzw. Flanke jeder der Schichten aus dem zweiten Material freigelegt werden. In den oben zitierten Patentanmeldungen sind andere Beispiele für die Erzeugung der Erfindung angegeben. Der verbleibende Spacer 6 stellt das Verbindungsteil dar. Die Schichten 5₂ aus dem zweiten Material werden mit einem Ätzprozeß mit isotroper Komponente entfernt, der die Schichten aus dem ersten Material, das Verbindungsteil 6, die Trägeroberfläche 2 und die Barriere 4 nicht angreift. Geeignete Ätzprozesse sind dem Fachmann bekannt und bspw. in den zitierten Patentanmeldungen beschrieben. Auf diese Weise ist ein Stützgerüst gebildet, das aus voneinander beabstandeten Lamellen 5₁ und dem Verbindungsteil 6 besteht. Das Verbindungsteil 6 verbindet die Lamellen 5₁ mechanisch miteinander und mit der Trägeroberfläche.

FIG 4: Auf das Stützgerüst 5₁, 6 wird konform als edelmetallhaltiges Elektrodenmaterial Platin 7 abgeschieden. Dazu geeignete Verfahren (insbesondere MOCVD) sind aus dem oben angegebenen US-Patent bekannt. Dann wird eine Hilfsschicht 8 konform aufgebracht, so daß die vorhandene Struktur damit gefüllt wird und die Oberfläche teilweise eingeebnet wird. Die Hilfsschicht muß zum Material der ersten Elektrode selektiv ätzbar sein und kann beispielsweise aus TEOS oder Nitrid bestehen.

FIG 5: Es wird eine geeignete Lackmaske (nicht dargestellt) aufgebracht und die Hilfsschicht und die Elektrodenschicht 7 werden anisotrop geätzt. Die Elektrodenschicht 7 ist dabei entsprechend dem Ausmaß der ersten Elektrode geätzt. Anschließend wird die Hilfsschicht 8 beispielsweise naß selektiv zum Elektrodenmaterial entfernt. Die erste Elektrode 7 bedeckt auch einen Teil der Trägeroberfläche und insbesondere den Anschluß 3, 4. Dadurch wird der elektrische Kontakt zwischen Anschluß und erster Elektrode gewährleistet.

FIG 6: Das Kondensatordielektrikum bestehend aus einem hoch-ε-Dielektrikum oder einem Ferroelektrikum 9 wird mit einem bekannten Verfahren aufgebracht. Der dabei eingesetzte Hochtemperaturprozess führt nicht zur Oxidation tieferliegender Strukturen, da eine Sauerstoffdiffusion durch die Barriere 4 vermieden wird. Schließlich wird eine leitende Schicht zur Bildung der Gegenelektrode 10 aufgebracht.

In dieser Figur 6 sind auch weitere im Träger realisierte Strukturen dargestellt, die bei Einsatz des Kondensators in einer DRAM-Schaltung vorhanden sind. Die erste Elektrode 7, die auf dem Stützgerüst 5₁, 6 angeordnet ist, bildet den sogenannten Speicherknoten für einen Speicherkondensator. Diese erste Elektrode ist über den darunter angeordneten und mit der Diffusionsbarriere 4 versehenen Kontakt 3 mit einem Source-/Drain-Gebiet 11 eines Auswahltansistors verbunden. Das andere Source-/Drain-Gebiet 12 des Auswahltransistors ist über einen Bitleitungskontakt 14 mit einer vergrabenen Bitleitung 15 verbunden. Vorzugsweise besitzen zwei benachbarte Speicherzellen einen gemeinsamen Bitleitungskontakt. Die vergrabene Bitleitung 15 und der Bitleitungskontakt 14 sind von der isolierenden Schicht 2 umgeben. Zwischen den Source-/Drain-Gebieten 11 und 12 eines Auswahltransistors sind das Kanalgebiet 16, ein Gatedielektrikum (nicht dargestellt) und eine als Wortleitung 17 wirkende Gateelektrode angeordnet. Die Wortleitung 17 und der Bitleitungskontakt 14 sind jeweils aus dotiertem Polysilizium gebildet. Die Bitleitung 15 wird aus dotiertem Polyslilizium, Wolframsilizid oder Wolfram gebildet. Auf der der Bitleitung 15 abgewandten Seite des S-/D-Gebietes 11 ist jeweils eine Isolationsstruktur, beispielsweise ein flacher mit isolierendem Material gefüllter Graben 18 zur Isolation zwischen benachbarten Auswahltransistorpaaren vorgesehen.

Bei einer weiteren Ausführungsform besteht das Stützgerüst, d.h. die Lamellen 5₁ und das Verbindungsteil 6, aus p-dotiertem Polysilizium. Die Schichtenfolge (s. Fig. 1) kann dann vorzugsweise aus p⁻-dotiertem Silizium 5₂ und p⁺-dotiertem Silizium 5₁ bestehen. Die unterste Schicht ist dabei eine p⁻-dotierte Polysiliziumschicht 5₂. Das Verbindungsteil (siehe Fig. 2) kann als Spacer wie im ersten Ausführungsbeispiel hergestellt werden, es kann aber auch durch selektive Epitaxie, wie sie in EP-779 656 A2 beschrieben ist, erzeugt werden. Dann ist die oberste Schicht der Schichtenfolge in Fig.1 vorzugsweise eine p⁻-dotierte Polysiliziumschicht 5₂ Eine weitere Möglichkeit ist die Erzeugung des Verbindungsteils durch eine Schrägimplantation in eine Seitenwand der Schichtstruktur 5 in Figur 1. Dann wird dieser Randbereich hochdotiert, während der gegenüberliegende Randbereich in seiner Dotierung nicht geändert wird. Ein derartiges Verfahren ist in EP 756 326 A1 beschrieben. In diesem Fall braucht keine weitere Öffnung in die Schichtstruktur 5 geätzt zu werden, da am gegenüberliegenden Rand die Flanken der Cshichten aus dem zweiten Material freiliegen. Nach Erzeugung des Verbindungsteils 6 werden die Schichten aus dem zweiten Material 5_{2,} also die p⁻-dotierten Siliziumschichten, selektiv zum p⁺-dotierten Polysilizium 5₁, 6 , zum Träger und zur Barriere entfernt. Geeignete Ätzverfahren sind dem Fachmann bekannt und beispielsweise in den oben zitierten Patentanmeldungen beschrieben. Damit ist das Stützgerüst fertiggestellt, und das weitere Verfahren kann wie im ersten Ausführungsbeispiel durchgeführt werden. Während des Hochtemperaturprozesses zur Erzeugung des Kondensatordielektrikums muß mit einer Oxidation des Stützgerüstes 5₁, 6 gerechnet werden. Dies ist aber unschädlich, da der elektrische Kontakt zwischen der ersten Elektrode und der Anschlußstruktur 3, 4 direkt erfolgt (s. Fig. 6) und die elektrische Leitfähigkeit des Stützgerüstes keine Rolle spielt.

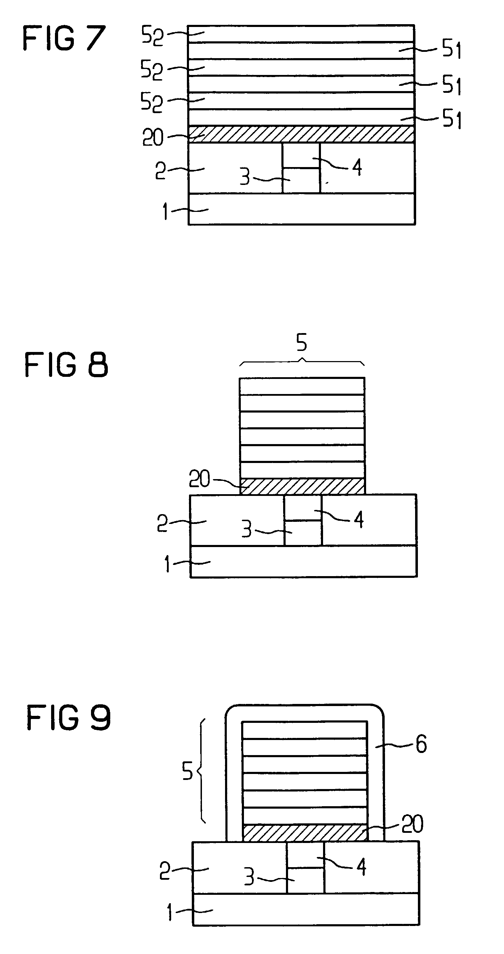

In den Figuren 7 - 12 ist ein weiteres Ausführungsbeispiel dargestellt.

FIG 7: Auf ein Substrat 1 wird eine isolierende Schicht 2 aufgebracht. Das Substrat 1 ist beispielsweise ein Siliziumsubstrat, das Auswahltransistoren mit Wortleitungen und Bitleitungen umfaßt (s. Fig.6). Die isolierende Schicht wird beispielsweise aus Siliziumoxid gebildet und planarisiert. In der isolierenden Schicht 2 werden Kontaktlöcher 3 geöffnet und mit elektrisch leitfähigem Material, beispielsweise mit dotiertem Polysilizium, Wolfram, Tantal, Titan, Titannitrid oder Wolframsilizid aufgefüllt. Die Kontaktlöcher 3 werden so angeordnet, daß sie jeweils auf ein Source-/Draingebiet eines Auswahltransistors im Substrat 1 reichen. Vorzugsweise im oberen Teil des Kontaktlochs 3 ist eine Barriere 4 angeordnet, die eine Sauerstoffdiffusion unterdrückt. Verfahren zur Herstellung einer solchen Barriere sind beispielsweise aus DE-196 40 246, De-196 40 448 bekannt. Auf diesem Träger wird nun das Stützgerüst hergestellt, indem zunächst eine Ätzstopschicht 20 und darauf eine Schichtenfolge aufgebracht werden, die alternierend eine Schicht 5₁ aus einem ersten Material und eine Schicht 5₂ aus einem zweiten Material umfaßt. In diesem Beispiel besteht das erste Material aus p⁺-dotiertem Polysilizium, das zweite Material aus p⁻-dotiertem Polysilizium und die Ätzstopschicht aus TEOS oder Nitrid. Die unterste Schicht der Schichtenfolge besteht aus dem ersten Material und die oberste Schicht der Schichtenfolge aus dem zweiten Material.

FIG 8: Anschließend werden aus der Schichtenfolge durch anisotropes Ätzen unter Verwendung einer Maske eine Schichtstruktur 5 gebildet, dabei wird - ggf. in einem zweiten Ätzschritt- auch die Ätzstopschicht 20 geätzt. Neben der Schichtstruktur liegt die Oberfläche der isolierenden Schicht 2 frei. Das anisotrope Ätzen kann mit CF₄ und SF₆ erfolgen.

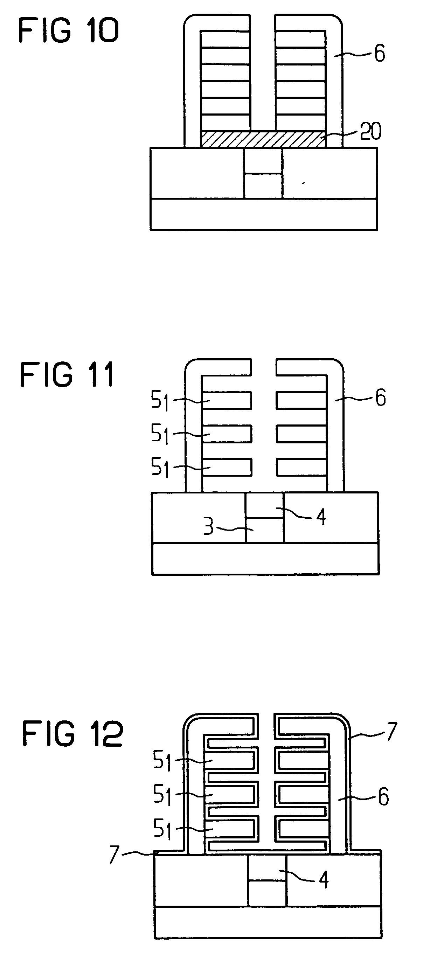

FIG 9: Die Schichtstruktur 5 aus p⁺-dotiertem Polysilizium und p⁻-dotiertem Polysilizium wird mittels selektiver Epitaxie von Silizium überwachsen, so daß das Verbindungsteil 6 gebildet wird, das die Schichtstruktur vollständig überdeckt. Die Epitaxie kann im Temperaturbereich zwischen 700°C und 750°C mit den Prozeßgasen SiCl₂H₂, HCl und H₂ sowie einem Dotiergas wie B₂H₆ durchgeführt werden, so daß ein Ineinanderdiffundieren der Schichten vermieden wird. Bei einer Schichtenfolge aus Silizium und germaniumhaltigen Schichten kann die Temperatur bis 900°C betragen.

FIG 10: Dann wird unter Einsatz einer Fotomaske eine Öffnung in diese Struktur geätzt, die die Flanken der Schichten aus dem ersten und aus dem zweiten Material freilegt. In diesem Ausführungsbeispiel wird diese Öffnung in das Innere der Struktur gelegt. In einem ersten anisotropen Ätzschritt z.B. mit HBr und Chlor wird die Schichtenfolge geätzt, in einem zweiten Ätzschritt mit isotroper Komponente wird die Ätzstopschicht, die den Anschluß 3,4 überdeckt, selektiv entfernt.

FIG 11: Die Schichten 5₂ aus dem zweiten Material werden mit einem Ätzprozeß mit isotroper Komponente entfernt, der die Schichten aus dem ersten Material und das Verbindungsteil 6 nicht angreift (ggf. vor oder gleichzeitig mit der Entfernung der Ätzstopschicht). Dazu kann eine alkalische Ätzlösung eingesetzt werden, die Ethylendiamin, Brengkatechin, Pyrazin und Wasser enthält. Die Selektivität (Ätzrate P⁺-Si/P⁻Si) beträgt etwa 1:500. Auf diese Weise ist ein Stützgerüst gebildet, das aus voneinander beabstandeten Lamellen 5₁ und dem Verbindungsteil 6 besteht. Das Verbindungsteil 6 verbindet die Lamellen 5₁ an allen Außenseiten des Stützgerüstes mechanisch miteinander und mit der Trägeroberfläche.

FIG 12: Auf das Stützgerüst 5₁, 6 wird konform als edelmetallhaltiges Elektrodenmaterial Platin abgeschieden. Im Bereich der Öffnung im Innern des Stützgerüstes ist der Anschluß 3,4 freigelegt, so daß hier der Kontakt mit der Elektrodenschicht 7 sichergestellt ist. Geeignete Verfahren zur konformen Platinabscheidung sind aus dem oben angegebenen US-Patent bekannt. Anschließend wird das Verfahren wie im ersten Ausführungsbeispiel fortgeführt , also ggf. die Hilfsschicht 8 konform aufgebracht (s. Fig.4ff) und die erste Elektrode strukturiert etc.

## Patentansprüche

1. Kondensator, der in einer Halbleiteranordnung auf einem Träger angeordnet ist,
- mit einer edelmetallhaltigen ersten Elektrode (7),
- mit einem Kondensatordielektrikum (9), das aus einem hoch-ε-dielektrischen oder ferroelektrischen Material besteht,
- mit einer zweiten Elektrode (10),
**dadurch gekennzeichnet,** daß
die erste Elektrode (7) auf der Oberfläche eines mit dem Träger verbundenen Stützgerüstes (5₁, 6) angeordnet ist, wobei das Stützgerüst mindestens zwei voneinander beabstandete Lamellen (5₁) aufweist, die im wesentlichen parallel zur Trägeroberfläche angeordnet sind und über ein Verbindungsteil (6) mit dem Träger (1, 2) mechanisch verbunden sind.

2. Kondensator nach Anspruch 1, bei dem das Stützgerüst aus Polysilizium besteht.

3. Kondensator nach Anspruch 1, bei dem das Stützgerüst aus Siliziumoxid besteht.

4. Kondensator nach einem der Ansprüche 1 bis 3, bei dem die edelmetallhaltige erste Elektrode (7) einen Teil der Trägeroberfläche (2, 4) bedeckt.

5. Kondensator nach einem der Ansprüche 1 bis 4, bei dem der Träger an seiner dem Kondensator zugewandten Oberfläche eine Isolierschicht (2) mit einem darin angeordneten Kontakt (3) aufweist, wobei der Kontakt (3) eine Diffusionsbarriere (4) umfaßt und mit der ersten Elektrode (7) verbunden ist.

6. Kondensator nach Anspruch 5, bei dem der Träger einen MOS-Transistor enthält und der Kontakt (3) ein S-/D-Gebiet (11) des Transistors mit der ersten Elektrode (7) verbindet.

7. Herstellverfahren für einen Kondensator nach Anspruch 1, bei dem auf der Oberfläche des Trägers (1, 2) ein Stützgerüst gebildet wird, das mindestens zwei voneinander beabstandete Lamellen (5₁) aufweist, die im wesentlichen parallel zur Trägeroberfläche angeordnet sind und über ein Verbindungsteil (6) mit dem Träger (1, 2) mechanisch verbunden sind,
- bei dem auf der freiliegenden Oberfläche des Trägers und des Stützgerüstes (5₁,6) ein edelmetallhaltiges erstes Elektrodenmaterial konform aufgebracht wird,
- bei dem das edelmetallhaltige erste Elektrodenmaterial zu einer ersten Elektrode (7) strukturiert wird,
- bei dem ein Kondensatordielektrikum (9) aus einem hoch-ε-dielektrischen oder ferroelektrischen Material auf der ersten Elektrode (7) konform aufgebracht wird,
- bei dem eine zweite Elektrode auf dem Kondensatordielektrikum erzeugt wird.

8. Verfahren nach Anspruch 7,
- bei dem zur Bildung des Stützgerüstes auf einen Träger (1, 2) eine alternierende Schichtenfolge aus einem ersten Material (5₁) und einem zweiten Material (5₂) aufgebracht wird,
- bei dem die Schichtenfolge zu einer Schichtstruktur (5) mit Flanken geätzt wird,
- bei dem ein Verbindungsteil (6) gebildet wird, das eine Flanke der Schichtstruktur (5) bedeckt,
- bei dem die Schichten (5₂) aus dem zweiten Material selektiv zu den Schichten (5₁) aus dem ersten Material und zum Verbindungsteil entfernt werden, so daß das Stützgerüst gebildet wird.

9. Verfahren nach Anspruch 8,
bei dem die Schichten aus dem ersten Material aus p⁺-dotiertem Polysilizium und die Schichten aus dem zweiten Material aus p⁻-dotiertem Polysilizium erzeugt werden.

10. Verfahren nach Anspruch 8, bei dem die Schichten aus dem ersten Material aus einem isolierenden Material gebildet werden.

11. Verfahren nach Anspruch 9, bei dem das Verbindungsteil (6) durch eine Schrägimplantation in die Flanke der Schichtstruktur (5) gebildet wird.

12. Verfahren nach einem der Ansprüche 8 bis 10, bei dem das Verbindungsteil (6) durch selektive Epitaxie oder durch konforme Abscheidung an allen freiliegenden Flanken der Schichtstruktur (5) und anschließende anisotrope Ätzung gebildet wird, und bei dem eine Öffnung in die Schichtstruktur geätzt wird, die eine Oberfläche der Schichten (5₁) aus dem ersten Material freilegt.

13. Verfahren nach einem der Ansprüche 8 bis 12, bei dem nach dem Aufbringen des ersten Elektrodenmaterials eine Hilfsschicht (8) konform aufgebracht wird, die Hilfsschicht (8) und das erste Elektrodenmaterial anisotrop zur Bildung der ersten Elektrode (7) strukturiert werden und die verbleibende Hilfsschicht (8) selektiv zur ersten Elektrode (7) entfernt wird.

14. Verfahren nach einem der Ansprüche 8 bis 13, bei dem vor der Bildung des Stützgerüstes (5₁, 6) eine Ätzstopschicht (20) auf die Trägeroberfläche aufgebracht wird.
